# EUROPÄISCHE PATENTSCHRIFT

(11) **EP 3 114 259 B1**
(45) Veröffentlichungstag und Bekanntmachung des Hinweises auf die Patenterteilung: **12.07.2023**
(21) Anmeldenummer: 15708218.1
(22) Anmeldetag: 06.03.2015
(51) Int. Cl.: C30B 11/00, C30B 29/06

(54) **HYBRIDTIEGEL ZUR KRISTALLISATION VON MATERIALIEN**
HYBRID CRUCIBLE FOR CRYSTALLIZING MATERIALS
CREUSET HYBRIDE POUR LA CRISTALLISATION DES MATÉRIAUX

(30) Priorität: 06.03.2014 DE 102014102980
(43) Veröffentlichungstag der Anmeldung: 11.01.2017
(73) Patentinhaber: ALD Vacuum Technologies GmbH, 63457 Hanau (DE)
(72) Erfinder: FRANZ, Henrik, 63579 Freigericht (DE); MORCHE, Christoph, 63814 Mainaschaff (DE); ZIMMERMANN, Andreas, 63454 Hanau (DE); WENGERTER, Armin, 63911 Klingenberg (DE); MÜLLER, Kai, 63599 Biebergemünd (DE); HOHMANN, Michael, 63456 Hanau (DE)
(74) Vertreter: Fuchs Patentanwälte Partnerschaft mbB
(86) Internationale Anmeldenummer: PCT/EP2015/054762
(87) Internationale Veröffentlichungsnummer: WO 2015/132399

(56) Entgegenhaltungen:
- EP-A1- 1 717 201
- WO-A1-2007/148986
- WO-A1-2010/112259
- WO-A1-2011/120598
- WO-A1-2013/112231
- WO-A1-2013/149560
- WO-A2-2010/105617
- CN-A- 103 482 632
- JP-A- 2006 282 495
- US-A1- 2009 013 925

## Beschreibung

Die vorliegende Erfindung betrifft ein Verfahren zum Schmelzen und Kristallisieren von bestimmten Materialien, insbesondere von Silizium, in einem Hybridtiegel.

Im Stand der Technik werden für diese Zwecke vornehmlich Tiegel aus Siliziumdioxid (Quarzkeramik) verwendet. In den Tiegeln aus dem Stand der Technik wird das zu schmelzende Material komplett aufgeschmolzen. Um ein Auslaufen der Schmelze zu verhindern, sind diese Tiegel monolithisch aufgebaut, Rahmen und Bodenplatte sind also fest miteinander verbunden. Mit anderen Worten, Tiegel im Stand der Technik bestehen in der Regel aus Siliziumdioxid, wodurch die Wärmeleitfähigkeit in Richtung Boden und zu den Seiten gleich ist. Die nach dem Stand der Technik verwendeten Tiegel bedingen während des Erstarrungsvorgangs eine massive Erhöhung des Temperaturgradienten in Richtung des Hauptwärmeflusses. Diese massive Erhöhung des Temperaturgradienten verringert die Freiheitsgrade bei der Gestaltung des Kristallisationsprozesses. Zusätzlich kann es zu unerwünschtem Kristallwachstum kommen, das von der Hauptwachstumsrichtung abweicht, welches besonders im Bereich der Herstellung von kristallinem Silizium die Ausbeute an qualitativ hochwertigem Material verringern kann. Im Stand der Technik wird für die Herstellung kristalliner Siliziumblöcke üblicherweise das Bridgman-Verfahren oder VGF-Technik (vertical gradient freeze) verwendet.

Besonderes Augenmerk muss darauf gelegt werden, dass die Schmelze nicht durch Verunreinigungen kontaminiert wird. Im Falle von Silizium für die Photovoltaik würde dies zu einer Beeinträchtigung des Wirkungsgrades und einer verringerten Ausbeute führen.

Ein weiterer großer Nachteil der Tiegel des Standes der Technik besteht darin, dass der komplette Tiegel während des Prozesses durch Phasenumwandlungen und die damit verbundenen Volumenänderungen zerstört wird. Gegenwärtig müssen die verwendeten Tiegel sehr sorgfältig und vorsichtig manuell beladen werden. Bei fehlerhafter Herstellung und/oder unsachgemäßer Beladung des Tiegels können Schadstellen schon während des Schmelzprozesses zum Versagen und damit in Konsequenz zum Auslaufen der Schmelze führen. Die zu erwartenden weiteren Vergrößerungen der Chargengrößen und die damit einhergehende Tiegelvergrößerungen werden diese Probleme weiter verschärfen.

Das Dokument US 2008 0196656 A1 beschreibt Tiegel aus Quarzkeramik, die mit mehreren Beschichtungen versehen sind und sich für die Herstellung von kristallinen Siliziumblöcken eignen. Die Beschichtung der Tiegel soll dabei die Ausbildung von Rissen und Brüchen im Siliziumblock verhindern und ein Herauslösen des kristallisierten Siliziumblocks ermöglichen, ohne den Tiegel zu beschädigen. Solche Tiegel sind jedoch monolithisch aufgebaut und die Wärmeleitfähigkeit des Bodens und der Seitenwände sind gleich, was die oben beschriebenen Nachteile mit sich bringt. Zudem ist die Herstellung solcher Tiegel sehr umständlich und somit sehr teuer. SiO₂-Tiegel aus dem Stand der Technik werden üblicherweise deshalb zerstört, weil das eingangs amorphe Siliziumdioxid durch Hitzeeinwirkung in einen kristallinen Zustand übergeht (Hochtemperaturcristobalit). Dieser kristalline Zustand geht bei Abkühlung in das sogenannte Tieftemperaturcristobalit über. Mit dieser Umwandlung geht eine Volumenänderung einher, die zur Zerstörung des Tiegels führt.

Das Dokument JP 2000 351 688 A beschreibt ebenfalls Tiegel aus Quarzkeramik und deren Herstellung. Die Tiegel eignen sich für die Herstellung von Siliziumblöcken. Die Tiegel weisen einen gekrümmten inneren Boden auf, der in einen ebenen äußeren Boden eingefasst ist. Diese Anordnung soll den vollständigen Kontakt des Tiegels mit einer Kühlplatte gewährleisten, um eine gleichmäßige Kühlung des Tiegelbodens zu ermöglichen. Dies dient der Ausbildung einer gleichmäßigeren Erstarrungsfront bei der gerichteten Kristallisation von Siliziumblöcken im Bridgman-Verfahren und soll die Herstellung von Siliziumblöcken mit einer größeren Höhe ermöglichen. Solche Tiegel sind ebenfalls monolithisch aufgebaut und bringen die oben beschriebenen Nachteile mit sich.

Das Dokument US 2011/0180229 A1 beschreibt Tiegel, bei denen eine Bodenplatte in den Rahmen des Tiegels eingelegt wird. Dabei ist eine feste Verbindung der Bodenplatte mit dem Rahmen über einen Formschluss und über einen weiteren Stoffschluss vorgesehen. Der Tiegelrahmen ist also nicht auf die Bodenplatte aufgestellt und eine Lösung der Verbindung zwischen Tiegelrahmen und Bodenplatte ist arbeitsintensiv. Ein schneller Austausch des Rahmens ist somit nicht möglich. Zudem muss die Bodenplatte passgenau auf den Rahmen zugeschnitten sein. Solche Tiegel sind dementsprechend umständlich in der Handhabung und teuer in der Herstellung.

Das Dokument DE 10 2011 052 016 A1 beschreibt einen Bausatz für carbidkeramische Schmelztiegel. Ein solcher Bausatz sieht die feste Verbindung von Bodenplatte und Seitenelementen durch Formschluss und Stoffschluss vor, wobei der Rahmen ebenfalls nicht auf die Bodenplatte aufgestellt ist. Eine erhöhte Wärmeleitfähigkeit der Bodenplatte eines solchen Tiegels ist nicht vorgesehen. Solch ein fertiger Tiegel entspricht also im Grunde der Bauweise eines monolithischen Tiegels und bringt die entsprechenden oben beschriebenen Nachteile mit sich.

Das Dokument DE 10 2012 102 597 A1 beschreibt ein Verfahren zur Herstellung eines gerichtet erstarrten Materialkörpers. Dabei wird ein Schmelztiegel so vorbereitet, dass dessen Boden mit einer Mehrzahl von dünnen monokristallinen Keimkristallplatten bedeckt wird. Dies soll zu einer gerichteten Kristallisation von quasimonokristallinen Metall- oder Halbmetallkörpern führen. Die beschriebenen Tiegel sind ebenfalls monolithisch aufgebaut und bringen die beschriebenen Nachteile mit sich.

Das Dokument US 2009/0013925 A1 beschreibt eine Vorrichtung zur Herstellung eines Blocks eines kristallinen Materials aus einer Schmelze umfassend einen Tiegel mit einem Boden und unterhalb des Tiegels angeordneten Wärmeextraktionsmitteln sowie zwischen dem Boden und den Wärmeextraktionsmitteln angeordnete Modulationsvorrichtungen für die thermische Leitfähigkeit. Die Modulationsvorrichtungen umfassen eine Vielzahl von Platten aus einem thermisch leitfähigen Material, die parallel zum Boden angeordnet sind und über einen Mechanismus in ihrem Abstand zueinander und zum Boden verändert werden können.

Mithin besteht ein Bedarf, das Schmelzen und Kristallisieren so zu verbessern, dass eine bessere Kontrolle der Richtung des Kristallwachstums unter gleichzeitiger Verbesserung und Beschleunigung der Einstellung der Kristallisationsgeschwindigkeit möglich wird. Ferner soll das Verfahren dahingehend optimiert werden, dass die Kosten für die Tiegel möglichst gering sind. Es ist die Aufgabe dieser Erfindung, die genannten Verbesserungen herbeizuführen.

Die Aufgabe wird durch die Gegenstände der Patentansprüche gelöst.

Erfindungsgemäß nutzt das Verfahren einen Hybridtiegel zur Kristallisation von Materialien, umfassend eine Bodenplatte und einen Rahmen, wobei die Bodenplatte und der Rahmen aus unterschiedlichen Werkstoffen gefertigt sind, die Wärmeleitfähigkeit der Bodenplatte größer ist als die des Rahmens und der Rahmen auf der Bodenplatte aufgestellt ist. Durch den Unterschied der Wärmeleitfähigkeit von Bodenplatte und Rahmen wird über die gesamte Kristallisationshöhe der Temperaturgradient zwischen Mitte und Rändern der Kristallisationsfront vernachlässigbar klein gehalten, so dass während der gesamten Kristallisation im gesamten Ingot eine bevorzugte Wachstumsrichtung der Kristalle bzw. des Kristalls senkrecht von unten nach oben vorliegt. Unerwünschtes seitliches Kristallwachstum, das die Ausbeute an kristallinem Material verringern würde, wird vermieden.

Erfindungsgemäß ist der Rahmen auf die Bodenplatte aufgestellt. Damit ist gemeint, dass Bodenplatte und Rahmen nicht wie im Stand der Technik üblich aus einem Stück gefertigt sind, sondern lösbar miteinander verbunden werden. Die lösbare Verbindung besteht erfindungsgemäß darin, dass der Rahmen auf die Bodenplatte aufgestellt wird. Erfindungsgemäß besteht also kein Formschluss und/oder Stoffschluss zwischen Rahmen und Bodenplatte.

Aufgrund der besonderen Ausgestaltung des erfindungsgemäßen Verfahrens zum Schmelzen und Kristallisieren ist es nicht erforderlich, eine feste Verbindung zwischen Bodenplatte und Rahmen herzustellen. Insbesondere ist ein Formschluss und/oder Stoffschluss erfindungsgemäß nicht notwendig und nicht vorhanden. Der Hintergrund ist, dass das zu schmelzende und zu kristallisierende Material nicht bis auf die Bodenplatte des Hybridtiegels aufgeschmolzen wird, sondern eine feste Bodenschicht aus arteigenem Material auf der Bodenplatte verbleibt, so dass diese einerseits den Spalt zwischen Rahmen und Bodenplatte abdichtet und andererseits die Bodenplatte vor dem Angriff des Materials schützt.

Diese Ausgestaltung erlaubt es ferner, die Bodenplatte für mehr als einen Kristallisationsvorgang zu verwenden. Schließlich ist die Bodenplatte durch die feste Bodenschicht aus arteigenem Material vor dem Angriff der Schmelze geschützt. Der Rahmen, der in einer Ausführungsform dieser Erfindung nicht durch eine Schicht aus arteigenem Material geschützt ist, kann nach einem Schmelzgang ausgetauscht werden, sofern ein nennenswerter Abtrag durch die Schmelze erfolgt ist oder aber Umwandlungsvorgänge zur Beschädigung des Tiegels geführt haben, die eine Weiterverwendung unsicher machen.

Es hat sich als vorteilhaft erwiesen, für den Rahmen ein Material zu verwenden, welches bei 0°C eine Wärmeleitfähigkeit von höchstens 30 W/(m*K), weiter bevorzugt höchstens 20 W/(m*K) und mehr bevorzugt höchstens 10 W/(m*K) aufweist. Weiter bevorzugt ist, dass die Wärmeleitfähigkeit des Rahmens bei 0 °C einen Wert von höchstens 5 W/(m*K), weiter bevorzugt höchstens 3 W/(m*K) aufweist. Eine zu hohe Wärmeleitfähigkeit des Rahmens erschwert die gerichtete Erstarrung in Vorzugsrichtung. Messmethoden zur Bestimmung der Wärmeleitfähigkeit der Materialien sind dem Fachmann bekannt.

Die Differenz der Wärmeleitfähigkeit zwischen Rahmen und Bodenplatte sollte wenigstens 10 W/(m*K) betragen. Es hat sich als besonders vorteilhaft erwiesen, die Materialien so auszuwählen, dass die Wärmeleitfähigkeit der Bodenplatte erfindungsgemäß wenigstens um den Faktor 1,1, weiter bevorzugt wenigstens 1,3, mehr bevorzugt wenigstens 1,5 und besonders bevorzugt wenigstens 2 größer ist als die Wärmeleitfähigkeit des Rahmens. Sofern nichts anderes angegeben ist, wird die Wärmeleitfähigkeit bei 0°C bestimmt.

Materialien, die als Material des Rahmens geeignet sind, sind insbesondere oxidkeramische Materialien. Erfindungsgemäß ist es besonders bevorzugt, hierfür Siliziumdioxid zu verwenden. Der Rahmen wird vorzugsweise mit einer Schutzschicht versehen, insbesondere mit einer Nitridschutzschicht, vorzugsweise aus Siliziumnitrid. Eine solche Schutzschicht verhält sich gegenüber der Schmelze weitgehend inert und übersteht sehr hohe Temperaturen.

Die Wärmeleitfähigkeit des Materials der Bodenplatte ist bei 0 °C vorzugsweise >10 W/(m*K), weiter bevorzugt wenigstens 13 W/(m*K), mehr bevorzugt wenigstens 20 W/(m*K), ferner bevorzugt wenigstens 25 W/(m*K) und ganz besonders bevorzugt wenigstens 30 W/(m*K). In erfindungsgemäß bevorzugten Ausführungsformen ist die Wärmeleitfähigkeit sogar noch höher, insbesondere wenigstens 40 W/(m*K) und besonders bevorzugt wenigstens 50 W/(m*K).

In besonders bevorzugten Ausführungsformen besteht die Bodenplatte aus einem Material, welches bei der Schmelztemperatur des zu kristallisierenden Materials fest ist, insbesondere aus einem metallischen Material. Darunter werden Metalle und Metalllegierungen verstanden. Die Schmelztemperatur des Materials der Bodenplatte liegt vorzugsweise oberhalb von 600°C, weiter bevorzugt oberhalb von 800°C, weiter bevorzugt oberhalb von 1000°C und weiter bevorzugt oberhalb von 1200°C. Diese Erfindung betrifft bevorzugt die Herstellung von kristallinem Silizium. Daher werden vorzugsweise Materialien für die Bodenplatte verwendet, die Temperaturen von mehr als 1410°C unbeschadet überstehen. In einer alternativen Ausführungsform besteht die Bodenplatte im Wesentlichen aus einem graphithaltigen Material, insbesondere aus Graphit. Die Bodenplatte ist vorzugsweise nicht aus keramischem, insbesondere nicht aus einem oxidkeramischen Material.

Erfindungsgemäß ist auch die Verwendung eines beschriebenen Hybridtiegels in einem Verfahren zur Herstellung kristalliner Materialien, insbesondere einkristalliner oder polykristalliner Materialien (insbesondere Silizium).

Der Innendurchmesser des Hybridtiegels beträgt vorzugsweise wenigstens 10 cm, weiter bevorzugt wenigstens 30 cm und besonders bevorzugt wenigstens 50 cm und insbesondere höchstens 400 cm, weiter bevorzugt höchstens 300 cm und besonders bevorzugt höchstens 200 cm. Gemeint ist der jeweils größte Innendurchmesser.

Erfindungsgemäß ist ein Verfahren zur Herstellung von kristallinem Material, umfassend die Schritte:
a. Einfüllen von Rohmaterial in einen Hybridtiegel zum Schmelzen und Kristallisieren von bestimmten Materialien, insbesondere von Silizium, umfassend eine Bodenplatte und einen Rahmen, wobei
   - Bodenplatte und Rahmen aus unterschiedlichen Werkstoffen gefertigt sind,
   - die Wärmeleitfähigkeit der Bodenplatte wenigstens um den Faktor 1,1 größer ist als die des Rahmens, und
   - der Rahmen (2) auf der Bodenplatte (1) aufgestellt ist, ohne dass vor der Verwendung des Tiegels ein Formschluss und/oder Stoffschluss von Rahmen (2) und Bodenplatte (1) erfolgt
b. Wärmeeintrag, so dass das Material von oben nach unten aufschmilzt,
c. Erstarrung der Schmelze zu einem kristallinen Produkt,
wobei auf der Bodenplatte während des gesamten Prozesses ein Anteil ungeschmolzenen Materials verbleibt, welcher die Bodenplatte vor dem Angriff der Schmelze schützt.

Die Zugabe des Rohmaterials bzw. das Chargieren kann in fester oder bereits geschmolzener Form erfolgen. Das kristalline Produkt kann mono- oder polykristallin sein. Der Wärmeeintrag erfolgt vorzugsweise mit Hilfe einer Heizeinrichtung, die insbesondere ausgewählt ist aus einer oder mehrerer Widerstands- und/oder Induktionsheizeinrichtungen.

Vor dem Einfüllen des Rohmaterials kann ein sogenanntes Seed-Material eingefüllt werden, welches ebenfalls aus dem verwendeten Rohmaterial besteht, allerdings gegebenenfalls in kleinerer Partikelgröße. Dieses Seed-Material wird während der Schmelze nicht bzw. nicht vollständig verflüssigt, sondern verbleibt als feste Bodenschicht bzw. Anteil ungeschmolzenen Materials auf der Bodenplatte.

Eine Ausführungsform der Erfindung sieht die Verwendung eines Schutzrahmens vor, welcher vor dem Einfüllen des Rohmaterials auf die Bodenplatte aufgestellt wird. Der Schutzrahmen wird vor dem Wärmeeintrag bzw. vor dem Schmelzen wieder entfernt. Er dient dem Schutz des Rahmens während des Einfüllens des Rohmaterials, um Schäden am Rahmen durch die oft scharfkantigen Rohmaterialien zu vermeiden. In einer Ausführungsform wird in einem ersten Schritt der Schutzrahmen auf die Bodenplatte aufgestellt, sodann das Seed-Material vorgelegt und anschließend Rohmaterial in den Schutzrahmen eingefüllt. Das Einfüllen kann durch einfaches Schütten - auch maschinell - erfolgen, da auf die Unversehrtheit des Rahmens nicht geachtet werden muss. Der Rahmen selbst kann zum Zeitpunkt des Einfüllens bereits auf der Bodenplatte stehen und den Schutzrahmen umgeben oder aber erst nach dem Einfüllen über den Schutzrahmen geführt werden. In jedem Fall ist der Rahmen auf der Bodenplatte aufgestellt, wenn der Schutzrahmen entfernt wird.

Ein erfindungsgemäß bevorzugtes Verfahren weist also die folgenden Schritte auf:
A. Aufstellen des Schutzrahmens auf die Bodenplatte,
B. Ggf. Einfüllen von Seedmaterial auf die Bodenplatte im Schutzrahmen,
C. Einfüllen von Rohmaterial auf das Seed-Material,
D. Entfernen des Schutzrahmens,
E. Wärmeeintrag, so dass das Material von oben nach unten aufschmilzt,
F. Erstarrung der Schmelze zu einem kristallinen Produkt, wobei auf der Bodenplatte während des gesamten Prozesses ein Anteil ungeschmolzenen Materials verbleibt und spätestens zum Zeitpunkt der Schmelze des Rohmaterials der Rahmen auf die Bodenplatte aufgestellt ist.

In der erfindungsgemäßen Ausführungsform erfolgt der Wärmeeintrag in den Hybridtiegel beim Schmelzen so, dass das Rohmaterial von oben nach unten in Richtung der Bodenplatte aufschmilzt. Auf der Bodenplatte verbleibt ein Anteil ungeschmolzenen Materials, die sogenannte feste Bodenschicht. Die Temperatur an der Bodenplatte bleibt also vorzugsweise unterhalb der Schmelztemperatur des Materials. Beim Kristallisieren wird die Temperaturverteilung vorzugsweise so eingestellt, dass das Kristallwachstum von unten nach oben erfolgt.

Durch den Verbleib einer festen Bodenschicht auf der Bodenplatte des Hybridtiegels ergeben sich verschiedene Vorteile. Einerseits kann der Tiegel so ausgestaltet werden, dass eine feste Verbindung zwischen Rahmen und Bodenplatte nicht erforderlich ist, weil das Material der festen Bodenschicht eine Abdichtung des Spaltes zwischen Rahmen und Bodenplatte bewirkt. Eine Abdichtung, Formschluss und/oder Stoffschluss muss vor Beginn des Verfahrens nicht hergestellt werden. Ferner schützt die feste Bodenschicht auf der Bodenplatte die Bodenplatte vor dem Angriff der Schmelze. Hierdurch kann einerseits für die Bodenplatte ein Material verwendet werden, welches ansonsten aufgrund mangelnder Widerstandsfähigkeit oder Kontaminationsgefahr für die Verwendung in einem solchen Tiegel nicht geeignet wäre. Zusätzlich wird eine Kontamination der Schmelze im Bodenbereich des Hybridtiegels wirksam vermieden. Dadurch sinken die Anforderungen an das Material der Bodenplatte beträchtlich.

Der Rahmen und/oder der Schutzrahmen ist erfindungsgemäß bevorzugt monolithisch oder aus Einzelteilen zusammengesetzt. "Monolithisch" heißt, dass er nicht aus mehreren Einzelteilen zusammengebaut werden muss, sondern aus einem Stück besteht. Der Rahmen ist zur Bodenplatte hin offen.

Insgesamt wird mit dem erfindungsgemäßen Verfahren unter Anwendung des Hybridtiegels ein Produkt erhalten, das im Hinblick auf die Produkte des Standes der Technik eine bessere Qualität mit weniger Verunreinigungen, mindestens jedoch die gleiche Qualität bei reduzierten Herstellungskosten, aufweist. Außerdem ist zu erwarten, dass bei den prognostizierten Vergrößerungen der Chargengröße die monolithischen Tiegel an Grenzen hinsichtlich sicheren Umgangs und Freiheitsgraden bei der Prozessführung gelangen werden. Das erfindungsgemäße Produkt kann ein- oder polykristallin sein. Das Verfahren ist insgesamt wirtschaftlicher, weil die Materialausbeute aufgrund geringerer Verunreinigung und unerwünschten Kristallwachstums deutlich erhöht ist.

Ferner kann die Bodenplatte des Tiegels mehrmals verwendet werden, weil sie durch die feste Bodenschicht vor dem Angriff der Schmelze geschützt ist. In einer bevorzugten Ausführungsform des erfindungsgemäßen Verfahrens schließt sich dem Erstarrenlassen der Schmelze ein Schritt der Entnahme des Produktes an; danach wird vorzugsweise der Rahmen des Hybridtiegels ersetzt. Die Bodenplatte kann wieder verwendet werden.

Der Rahmen kann nach Abschluss der Kristallisation bzw. Erstarrung der Schmelze entfernt, insbesondere nach oben abgehoben werden, so dass der erstarrte bzw. kristallisierte Körper auf der Bodenplatte verbleibt und seiner weiteren Bearbeitung zugeführt werden kann.

Das arteigene Material der festen Bodenschicht verhindert weiterhin eine Kontamination der Schmelze durch das Material der Bodenplatte. Der vorzugsweise zweigeteilte Hybridtiegel bietet Möglichkeiten und Ansätze für ein zuverlässigeres Chargieren des Ausgangsmaterials, da ein Coating für die Bodenplatte - anders als im Stand der Technik - nicht notwendig und vorzugsweise nicht vorgesehen ist. Tiegel des Standes der Technik weisen üblicherweise ein Coating auf, um den Kontakt der Schmelze mit dem Tiegel zu verhindern. Daher muss beim Beladen des Tiegels mit dem Rohmaterial sehr vorsichtig vorgegangen werden, um eine Beschädigung des Coatings zu vermeiden. Erfindungsgemäß ist ein Coating nicht notwendig und bevorzugt nicht vorhanden. Dies hängt auch damit zusammen, dass für die Bodenplatte ein weniger brüchiges Material verwendet werden kann als im Stand der Technik. Die keramischen Tiegel aus dem Stand der Technik können beim Chargieren leicht Beschädigungen davon tragen, die fatale Folgen für den Tiegel haben können.

In einer bevorzugten Ausführungsform umfasst der Hybridtiegel neben dem Rahmen einen zusätzlichen Schutzrahmen, der nur beim Einfüllen des Rohmaterials und/oder des Seed-Materials zum Einsatz kommt. Der Schutzrahmen passt hinsichtlich seiner Abmessungen so in den Rahmen dass er die Innenwand des Rahmens vor Beschädigung beim Einfüllen des Rohmaterials schützt. Er ist vorzugsweise so geformt, dass er hinsichtlich Länge und Breite genau in den Rahmen passt, das heißt dass zwischen der Außenseite des Schutzrahmens und der Innenseite des Rahmens ein Abstand von vorzugsweise nicht mehr als 15 mm, weiter bevorzugt nicht mehr als 10 mm und besonders bevorzugt nicht mehr als 5 mm verbleibt. Die Wände des Schutzrahmens sind vorzugsweise 2 bis 50 mm dick, weiter bevorzugt 3 bis 25 mm und besonders bevorzugt 5 bis 15 mm dick. Diese Wandstärke hat sich als ausreichend erwiesen. Zu dick sollte der Schutzrahmen nicht sein, damit nicht ein zu breiter Spalt zwischen Rahmen und eingefüllten Material verbleibt.

Der Schutzrahmen hat eine Höhe, die vorzugsweise wenigstens der Füllhöhe des Rohmaterials in dem Rahmen entspricht. Der Schutzrahmen kann beispielsweise den Rahmen in der Höhe überragen, die gleiche Höhe haben oder unwesentlich niedriger sein als der Rahmen.

In einer bevorzugten Ausführungsform des Verfahrens wird vor dem Einfüllen des Rohmaterials und/oder Seed-Materials der Schutzrahmen in dem Rahmen positioniert, so dass der Schutzrahmen vorzugsweise ebenfalls auf der Bodenplatte aufgestellt ist. Alternativ kann der Schutzrahmen auch vor dem Aufstellen des Rahmens auf der Bodenplatte aufgestellt werden. Der Schutzrahmen verbleibt dann während des Einfüllens des Rohmaterials und/oder Seed-Materials auf der Bodenplatte, so dass die Innenwand des Rahmens vor Beschädigung durch scharfe Kanten des Rohmaterials geschützt ist. Dies ist besonders bei scharfkantigem Silizium als Rohmaterial von großem Vorteil.

Der Schutzrahmen kann vorzugsweise nach dem Einfüllen des Rohmaterials und/oder Seed-Materials insbesondere vor dem Wärmeeintrag bzw. der Schmelze wieder aus dem Bereich innerhalb des Rahmens entfernt werden. Der Schutzrahmen dient dann lediglich dem Schutz des Rahmens beim Einfüllen des Materials. Die Lebensdauer des Rahmens wird dadurch verlängert und die Gefahr von Kontamination des zu schmelzenden Materials wird vermindert. Nach der Entnahme des Schutzrahmens verbleibt ein kleiner Spalt zwischen dem eingefüllten Material und der Innenwand des Rahmens. Dieser Spalt schließt sich natürlich während der Schmelze.

Durch die Verwendung des Schutzrahmens kann eine automatisierte Befüllung des Hybridtiegels erfolgen, da nicht mehr mit besonderer Vorsicht befüllt werden muss. Der Schutzrahmen kann mehrmals verwendet werden, insbesondere wenn er aus Silizium besteht, da er dann nicht zu Kontamination führt, selbst wenn er beschädigt wird.

Der Schutzrahmen selbst kann aus einem Material gefertigt sein, das der mechanischen Belastung durch scharfkantiges Rohmaterial widersteht. Er muss nicht notwendigerweise hitzebeständig sein, sollte aber gegenüber dem Rohmaterial inert sein, also keine Kontamination hervorrufen. In einer Ausführungsform besteht der Schutzrahmen aus einem Material (wie einem Metall), das mit Silizium ummantelt ist, oder aus Silizium. Alternativ können auch andere Materialien wie nitridbeschichtete Metalle verwendet werden.

In einer bevorzugten Ausführungsform ist die Bodenplatte aus einem Verbundwerkstoff, insbesondere einem Gradientenwerkstoff aufgebaut. Die Bodenplatte kann also eine gezielte Verteilung der Wärmeleitfähigkeit im Material aufweisen. Der Verbundwerkstoff kann ein Schichtwerkstoff sein. Die Bodenplatte kann lokal unterschiedliche Wärmeleitfähigkeiten aufweisen, so dass lokal unterschiedliche Wärmeflüsse etabliert werden können.

### Figurenbeschreibung

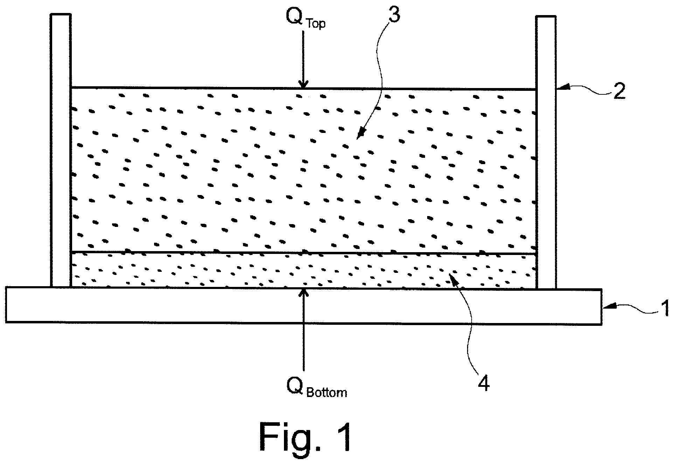

Figur 1 zeigt eine Schnittansicht des Hybridtiegels für das erfindungsgemäße Verfahren mit einer Bodenplatte 1 und einem Rahmen 2, der auf die Bodenplatte aufgestellt ist. In dem Hybridtiegel befindet sich eine Schmelze 3 und eine feste Bodenschicht 4 aus eigenem Material. Mit dem Begriff "arteigenes" Material ist gemeint, dass das Material dasselbe ist wie das der Schmelze. Die feste Bodenschicht besteht also aus demselben Material wie die Schmelze darüber. In dieser Abbildung ist die Schmelzphase innerhalb des erfindungsgemäßen Verfahrens gezeigt. Während der Schmelzphase wird vorzugsweise sowohl von oben Qₜₒₚ als auch von unten Q_{Bottom} Wärme zugeführt. Durch den Rahmen hindurch wird vorzugsweise keine Wärme zugeführt, weil dieser eine schlechtere Wärmeleitfähigkeit aufweist.

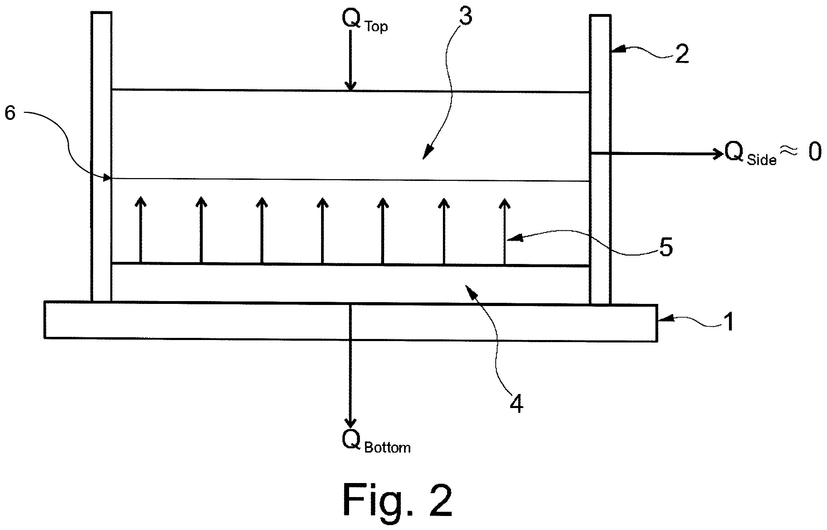

Figur 2 zeigt wie Figur 1 eine Schnittansicht des Hybridtiegels für das erfindungsgemäße Verfahren mit einer Bodenplatte 1, einem Rahmen 2, der Schmelze 3 und der festen Bodenschicht 4. Die Pfeile 5 zeigen die Richtung des Kristallwachstums an der Kristallisationsfront 6 an. Während der Kristallisationsphase, welche in dieser Abbildung gezeigt ist, wird durch die Kombination von Heizung und Kühlung ein Wärmefluss durch die Bodenplatte realisiert, der in erster Konsequenz zur Etablierung eines Temperaturgradienten und in weiterer Konsequenz zur gerichteten Erstarrung führt. Von oben wird weiter Wärme zugeführt (Q_{Top}). Die Wärmeabfuhr über den Rahmen (Q_{side}) ist gering.

Dadurch, dass der Rahmen isolierende Wirkung zeigt, ist der Energieaustrag an den Seiten äußerst gering. Folglich entsteht nur zwischen Kristallisationsfront und Bodenplatte ein Temperaturgradient. Das Kristallwachstum erfolgt somit nur von unten nach oben.

### Bezugszeichenliste

| | |
|---|---|
| 1 | Bodenplatte |
| 2 | Rahmen |
| 3 | Schmelze |
| 4 | Feste Bodenschicht |
| 5 | Richtung des Kristallwachstums |
| 6 | Kristallisationsfront |

## Patentansprüche

1. Verfahren zur Herstellung von kristallinem Material, umfassend die Schritte
a. Einfüllen von Rohmaterial, bevorzugterweise einem Silizium-Rohmaterial, in einen Hybridtiegel zum Schmelzen und Kristallisieren von bestimmten Materialien, insbesondere von Silizium, umfassend eine Bodenplatte (1) und einen Rahmen (2), wobei
- Bodenplatte (1) und Rahmen (2) aus unterschiedlichen Werkstoffen gefertigt sind,
- die Wärmeleitfähigkeit der Bodenplatte (1) wenigstens um den Faktor 1,1 größer ist als die des Rahmens (2), und
- der Rahmen (2) auf der Bodenplatte (1) aufgestellt ist, ohne dass vor der Verwendung des Tiegels ein Formschluss und/oder Stoffschluss von Rahmen (2) und Bodenplatte (1) erfolgt,
b. Wärmeeintrag in den Hybridtiegel, so dass das Rohmaterial von oben nach unten aufschmilzt,
c. gerichtete Erstarrung der Schmelze (3) zu einem kristallinen Produkt, wobei auf der Bodenplatte (1) während des gesamten Prozesses ein Anteil ungeschmolzenen Materials (4) verbleibt, welcher die Bodenplatte (1) vor dem Angriff der Schmelze (3) schützt.

2. Verfahren nach Anspruch 1, wobei das Verfahren, bevorzugt vor Schritt a), weiter umfasst, Einfüllen eines Seed-Materials bestehend aus dem Rohmaterial, wobei das Seed-Material so ausgestaltet ist, dass es sich während der Schmelze nicht oder nicht vollständig verflüssigt und auf der Bodenplatte (1) während des gesamten Prozesses als der Anteil ungeschmolzenen Materials (4) verbleibt.

3. Verfahren nach wenigstens einem der vorhergehenden Ansprüche, wobei die Bodenplatte (1) lokal unterschiedliche Wärmeleitfähigkeiten aufweist, so dass lokal unterschiedliche Wärmeflüsse etabliert werden können.

4. Verfahren nach wenigstens einem der vorhergehenden Ansprüche, wobei vor dem Einfüllen ein Schutzrahmen auf der Bodenplatte (1) angeordnet wird, wobei der Schutzrahmen vor dem Wärmeeintrag wieder entfernt wird.

5. Verfahren nach wenigstens einem der vorhergehenden Ansprüche, wobei der Schutzrahmen vor dem Aufstellen des Rahmens (2) auf die Bodenplatte (1) aufgestellt wird.

6. Verfahren nach wenigstens einem der vorhergehenden Ansprüche, wobei der Rahmen (2) nach der Entnahme des kristallinen Materials ersetzt und das Verfahren anschließend mit einem neuen Rahmen (2) erneut durchgeführt wird.

## Claims

1. A method for the production of crystalline material, comprising the steps
a. filling in of raw material, preferably a silicon raw material, into a hybrid crucible for the melting and crystallization of certain materials, in particularly of silicon, comprising a bottom plate (1) and a frame (2), wherein
- bottom plate (1) and frame (2) are manufactured from different substances,
- the thermal conductivity of the bottom plate (1) is higher than that of the frame (2) by a factor of at least 1.1, and
- the frame (2) is positioned on the bottom plate (1) without any form closure and/or material closure of frame (2) and bottom plate (1) before the crucible is used,
b. heat input into the hybrid crucible so that the raw material melts from top to bottom,
c. directional solidification of the melt (3) to a crystalline product, wherein on the bottom plate (1) during the whole process a portion of unmelted material (4) remains, which protects the bottom plate (1) from the attack by the melt (3).

2. The method according to claim 1, wherein the method, preferably before step a), further comprises filling in of a seed material consisting of the raw material, wherein the seed material is designed such that during the melting it does not or not completely become liquid and that it remains on the bottom plate (1) during the whole process as the portion of unmelted material (4).

3. The method according to at least one of the preceding claims, wherein the bottom plate (1) has locally different thermal conductivities so that locally different heat flows can be established.

4. The method according to at least one of the preceding claims, wherein before the filling in a protective frame is arranged on the bottom plate (1), wherein the protective frame before the heat input is removed again.

5. The method according to at least one of the preceding claims, wherein the protective frame is positioned before the positioning of the frame (2) on the bottom plate (1).

6. The method according to at least one of the preceding claims, wherein the frame (2) after the extraction of the crystalline material is replaced and subsequently the method is conducted with a new frame (2) again.

## Revendications

1. Procédé de préparation d'une matière cristalline, comprenant les étapes
a. remplissage d'une matière première, de préférence une matière première à base de silicium, dans un creuset hybride pour faire fondre et cristalliser certaines matières, en particulier du silicium, comprenant une plaque de fond (1) et un cadre (2), dans lequel
- la plaque de fond (1) et le cadre (2) sont fabriqués à partir de différentes matériaux,
- la conductivité thermique de la plaque de fond (1) est au moins supérieur au facteur 1,1 que celle du cadre (2), et
- le cadre (2) est monté sur la plaque de fond (1), sans qu'une liaison de forme et/ou liaison de matière du cadre (2) et de la plaque de fond (1) ne s'effectue avant l'utilisation du creuset,
b. apport thermique dans le creuset hybride, de sorte que la matière première fonde de haut en bas,
c. solidification directionnelle de la masse fondue (3) en un produit cristallin, dans lequel une quantité de matière non fondue (4) reste sur la plaque de fond (1) tout au long du processus, laquelle protège la plaque de fond (1) avant l'attaque de la masse fondue (3).

2. Procédé selon la revendication 1, dans lequel le procédé, de préférence avant l'étape a), comprend en outre, le remplissage d'une matière à base de graines se composant de la matière première, dans lequel la matière à base de graines est conçue de telle manière qu'elle ne se liquéfie pas ou pas entièrement pendant la fusion et reste sur la plaque de fond (1) tout au long du processus en tant que la quantité de matière non fondue (4).

3. Procédé selon au moins l'une quelconque des revendications précédentes, dans lequel la plaque de fond (1) présente des conductivités thermiques localement différentes, de sorte que des flux de chaleur localement différents peuvent être établis.

4. Procédé selon au moins l'une quelconque des revendications précédentes, dans lequel un cadre de protection est disposé sur la plaque de fond (1) avant le remplissage, dans lequel le cadre de protection est à nouveau retiré avant l'apport thermique.

5. Procédé selon au moins l'une quelconque des revendications précédentes, dans lequel le cadre de protection est monté avant le montage du cadre (2) sur la plaque de fond (1).

6. Procédé selon au moins l'une quelconque des revendications précédentes, dans lequel le cadre (2) est remplacé après le retrait de la matière cristalline et le procédé est ensuite à nouveau réalisé avec un nouveau cadre (2).
